# EUROPEAN PATENT APPLICATION

(11) **EP 4 746 033 A1**
(43) Date of publication of application: **20.05.2026**
(21) Application number: 24858295.9
(22) Date of filing: 13.08.2024
(51) Int. Cl.: H01L 21/687, H01L 21/683, H01L 21/67, C23C 16/455, C23C 16/458

(54) **BEARING DEVICE AND SEMICONDUCTOR PROCESS APPARATUS**

(30) Priority: 28.08.2023 CN 202311086936
(71) Applicant: Beijing NAURA Microelectronics Equipment Co., Ltd., Beijing 100176 (CN)
(72) Inventor: TIAN, Xiqiang, Beijing 100176 (CN); DONG, Tao, Beijing 100176 (CN); YE, Hua, Beijing 100176 (CN); LIU, Guojie, Beijing 100176 (CN)
(74) Representative: Cohausz & Florack
(86) International application number: PCT/CN2024/111666
(87) International publication number: WO 2025/044752

(57) **Abstract**

Present disclosure provides a carrying device and a semiconductor processing apparatus. In this carrying device, a second gas distribution passage group surrounds the periphery of an annular passage; a plurality of first connecting passages are located in the space enclosed by the annular passage, one end of each first connecting passage serves as a gas inlet, and the other end is connected to the annular passage; the annular passage and the second gas distribution passage group are connected through a plurality of second connecting passages; and, the plurality of second connecting passages are spaced apart along a circumferential direction of the annular passage. This solution can effectively improve the distribution uniformity of the purging gas blown towards the edge region of the wafer in the circumferential direction, thereby improving process uniformity.

## Description

### TECHNICAL FIELD

The present disclosure generally relates to the semiconductor manufacturing field and, more particularly, to a carrying device and semiconductor processing apparatus.

### BACKGROUND

Atomic layer deposition (ALD) equipment and chemical vapor deposition (CVD) equipment are widely used in today's integrated circuit semiconductor manufacturing processes. To prevent side deposition and back deposition on the wafer, the carrying device (e.g., a carrier) used to support the wafer is equipped with an edge purge function to blow away reactive gases from the back and sides of the wafer, thereby preventing side deposition and back deposition on the wafer.

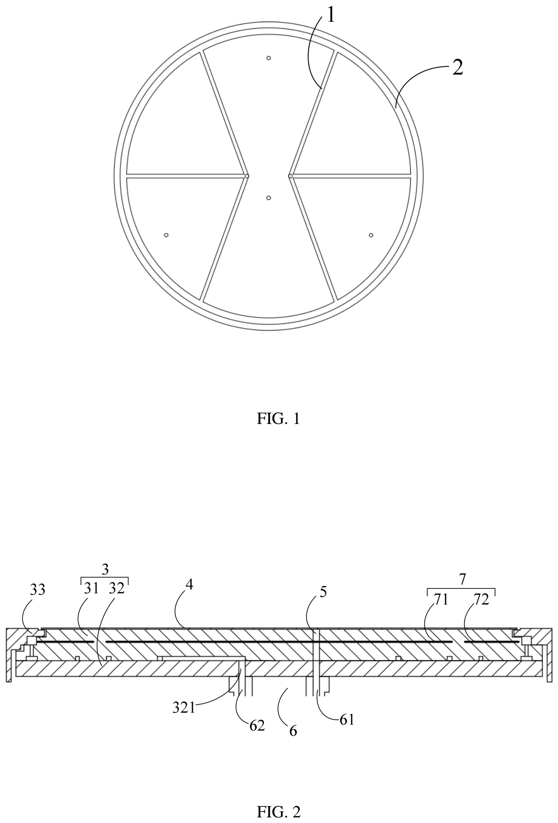

As shown in FIG. 1, the purging passage structure in existing carrying devices guides the purging gas through multiple horizontal straight passages 1 to a buffer chamber 2 at the edge of the chuck, and then guides the purging gas through corresponding passages to the edge region of the wafer, so that the purging gas can be blown towards the back and sides of the wafer. FIG. 1 only shows the horizontal straight passages 1 and the buffer chamber 2. Due to the limited number of horizontal straight passages 1 arranged circumferentially, the gas flow distribution in the circumferential direction is uneven. Furthermore, the horizontal straight passages 1 are easily affected by fluctuations in gas source pressure or flow rate, which also leads to poor gas flow uniformity. Further, when substances such as solder on the chuck flow into the horizontal straight passages 1, it reduces width or depth of the passage, leading to increased gas flow resistance in the passages and variations in gas flow resistance between different passages. This results in uneven gas flow distribution in the buffer chamber 2 at the edge of the chuck, ultimately leading to poor distribution uniformity of the purging gas blown towards the edge region of the wafer in the circumferential direction.

### SUMMARY

The present disclosure aims to at least solve one of the technical problems existing in the prior art by providing a carrying device and semiconductor processing apparatus that can effectively improve the uniformity of the purging gas distribution in the circumferential direction towards the edge region of the wafer, thereby improving process uniformity.

A carrying device provided for achieving the purpose of the present disclosure, comprising a carrier surface for carrying a wafer. The carrying device is provided with a purging passage structure for transporting purging gas. The purging passage structure includes a first gas distribution passage group and a second gas distribution passage group that are interconnected. The first gas distribution passage group has an inlet for connecting to a gas source; the second gas distribution passage group has an outlet for blowing the purging gas towards the edge region of the wafer placed on the carrier surface;

The first gas distribution passage group includes at least one annular passage, a plurality of first connecting passages, and a plurality of second connecting passages, and the second gas distribution passage group surrounds the periphery of the annular passage;

The plurality of first connecting passages are all located in the space enclosed by the annular passage, one end of each first connecting passage serves as the inlet, and the other end is connected to the annular passage;

The annular passage and the second gas distribution passage group are connected through a plurality of second connecting passages; and the plurality of second connecting passages are spaced apart along the circumferential direction of the annular passage.

In some embodiments, there are multiple annular passages, which are nested and spaced apart from each other;

Each two adjacent annular passages, and the outermost annular passage and the second gas distribution passage group are connected through a plurality of second connecting passages; and the plurality of second connecting passages located on the same circumference are spaced apart along the circumference, and the second connecting passages located on different circumferences are staggered with each other;

The plurality of first connecting passages are all located in the space enclosed by the innermost annular passage, and the other end of the first connecting passage is connected to the innermost annular passage; the second gas distribution passage group surrounds the periphery of the outermost annular passage.

In some embodiments, the plurality of second connecting passages are uniformly distributed along the circumferential direction of the annular passage.

In some embodiments, the radial width of the innermost annular passage is greater than the radial width of the other annular passages;

The width of each second connecting passage connected to the innermost annular passage is greater than the width of each second connecting passage on other different circumferences.

In some embodiments, the radial width of the annular passages other than the innermost annular passage is the same or decreases from the inside to the outside.

In some embodiments, the radial width of the second connecting passages on different circumferences, other than the second connecting passages connected to the innermost annular passage, is the same or decreases from the inside to the outside.

In some embodiments, both the first connecting passages and the second connecting passages are arranged to extend radially along the carrier surface;

The position at which each first connecting passage connects to the innermost annular passage is located at a middle position between two adjacent second connecting passages that are connected to that annular passage.

In some embodiments, the position at which the second connecting passages on each circumference connect to the adjacent outer annular passage is located at a middle position between two adjacent second connecting passages on the adjacent outer circumference.

In some embodiments, the second gas distribution passage group includes a first buffer chamber, a plurality of first pressure-regulating passages, a second buffer chamber, and a plurality of second pressure-regulating passages, in which,

the first buffer chamber is annular and surrounds the periphery of the outermost annular passage, and is connected to the outermost annular passage through a plurality of the second connecting passages;

the second buffer chamber is annular and is spaced above the first buffer chamber, and the second buffer chamber and the first buffer chamber are connected through a plurality of the first pressure-regulating passages;

one end of each of the plurality of second pressure-regulating passages is connected to the second buffer chamber, and the other end of each of the plurality of second pressure-regulating passages serves as the gas outlet.

In some embodiments, the volume of the first buffer chamber is less than or equal to the volume of the second buffer chamber.

In some embodiments, the plurality of first pressure-regulating passages includes a plurality of vertically arranged first through holes and a plurality of vertically arranged second through holes, in which, one first through hole is provided on each side of each second connecting passage connected to the first buffer chamber;

one second through hole is provided on each side of each second connecting passage connected to the first buffer chamber, and the second through hole is located on a side of the first through hole on the same side thereof that is facing away from the second connecting passage.

In some embodiments, the carrying device includes a carrier body and an edge ring, in which the carrier body has a carrier surface, and the diameter of the carrier surface is smaller than the diameter of the wafer, so that the edge region of the wafer can be located outside the carrier surface; a first annular step member is formed on the top of the outer circumferential surface of the carrier body;

the edge ring includes an annular body, and a first annular flange is provided on the inner circumferential surface of the annular body, the first annular flange being spaced above the first annular step member, and at least a part of the first annular flange is located below the wafer, and the lower surface and inner circumferential surface of the first annular flange respectively form the second pressure-regulating passage with the upper surface of the first annular step member and the outer circumferential surface of the carrier body;

a second annular step member is formed on the outer circumferential surface of the carrier body and below the first annular step member, and a second annular flange is formed on the inner circumferential surface of the annular body and below the first annular flange, at least a part of the second annular flange is superimposed on the second annular step member, and the inner circumferential surface of the second annular flange, the outer circumferential surface of the first annular step member, the upper surface of the second annular step member, and the lower surface of the first annular flange form the second buffer chamber.

In some embodiments, the carrier body includes a top plate and a bottom plate superimposed on the lower surface of the top plate, in which a plurality of annular passages, a plurality of first connecting passages, a plurality of second connecting passages, and the first buffer chamber are formed between the upper surface of the bottom plate and the lower surface of the top plate;

a plurality of first pressure-regulating passages are formed through the top plate, and the outlet end of each of the first pressure-regulating passages is located on the upper surface of the second annular step member;

a plurality of gas inlet holes are provided through the bottom plate, one end of the plurality of gas inlet holes is connected to the plurality of gas inlets in a one-to-one correspondence, and the other end of the plurality of gas inlet holes is used to connect to the gas source.

As another technical solution, the present disclosure also provides a semiconductor processing apparatus, including a process chamber and a carrying device disposed in the process chamber, in which the carrying device is the aforementioned carrying device provided in the present disclosure.

The present disclosure has the following beneficial effects:

In the carrying device provided in the present disclosure, when the purging gas enters from the inlet of the first gas distribution passage group, it first flows through the multiple first connecting passages into the annular passage. Since multiple first connecting passages are provided, the purging gas can be divided into multiple paths from the inlet and simultaneously flow into the annular passage at multiple different positions along its circumference. This allows the purging gas to quickly spread out along the circumference of the annular passage, achieving uniform distribution in the circumferential direction, thereby improving the uniformity of the gas distribution. Then, the purging gas in the annular passage flows through the second connecting passages connected to the annular passage into the outermost second gas distribution passage group, and is transported by the second gas distribution passage group, and finally blown out from its outlet towards the edge region of the wafer placed on the carrier surface, achieving purging of the back and sides of the wafer. When the purging gas flows from each first connecting passage into the annular passage, it can quickly diffuse in the annular passage, achieving uniform distribution in the circumferential direction. This solves the problem of uneven gas flow distribution in the circumferential direction caused by directly transporting the purging gas to the outermost passage using straight passages in the prior art. Furthermore, the annular passage has lower gas flow resistance than a straight passage, and is less susceptible to fluctuations in gas source pressure or flow rate. This effectively improves the uniformity of the purging gas distribution in the circumferential direction towards the edge region of the wafer, thereby improving process uniformity.

The semiconductor processing apparatus provided in the present disclosure, by using the aforementioned carrying device provided in the present disclosure, can effectively improve the uniformity of the purging gas distribution in the circumferential direction towards the edge region of the wafer, thereby improving process uniformity.

### BRIEF DESCRIPTION OF THE DRAWINGS

FIG. 1 is a structural diagram of the horizontal straight passage and buffer chamber in the carrying device used in the related technology;
FIG. 2 is a cross-sectional view of the carrying device provided in the embodiment of the present disclosure;

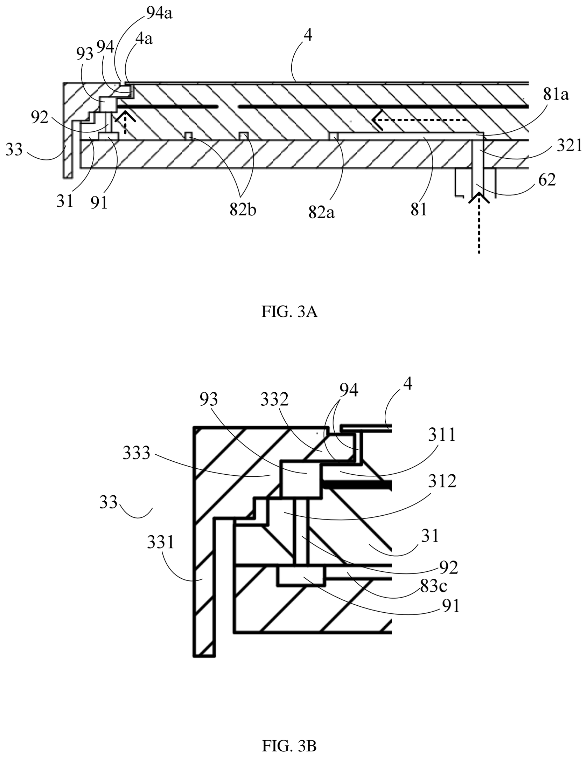

FIG. 3A is a partially enlarged view of the carrying device in FIG. 2;
FIG. 3B is a partially enlarged view of the carrying device in FIG. 2;
FIG. 4 is a top view of the first gas distribution passage group in the purging passage structure provided in the embodiment of the present disclosure;
FIG. 5 is a graph showing the relationship between gas flow rate and chuck diameter of the carrying device provided in the related technology;
FIG. 6 is a graph showing the relationship between gas flow rate and chuck diameter of the carrying device provided in the embodiment of the present disclosure.
FIG. 7 is a comparison of the curves shown in FIG. 5 and FIG. 6.

### DETAILED DESCRIPTION OF THE EMBODIMENTS

To enable those skilled in the art to better understand the technical solution of present disclosure, the carrying device and semiconductor processing apparatus provided in the present disclosure will be described in detail below with reference to the accompanying drawings.

Reference can be made to FIG.s 2 to 4. The embodiment of the present disclosure provides a carrying device, including a carrier surface for carrying a wafer 4. The carrying device is provided with a purging passage structure for transporting purging gas. The purging passage structure includes a first gas distribution passage group and a second gas distribution passage group that are interconnected. The first gas distribution passage group has a gas inlet for connecting to a gas source. The first gas distribution passage group is used to transport the purging gas from the gas source to the second gas distribution passage group, and simultaneously distribute the purging gas; the second gas distribution passage group has an outlet 94a for blowing the purging gas towards the edge portion 4a of the wafer 4 placed on the carrier surface. The second gas distribution passage group is used to transport the purging gas distributed by the first gas distribution passage group to the edge of the wafer 4 on the carrier surface, and further distribute the purging gas, finally blowing it out from its outlet 94a towards the edge region of the wafer 4, thereby achieving purging of the back and sides of the wafer 4.

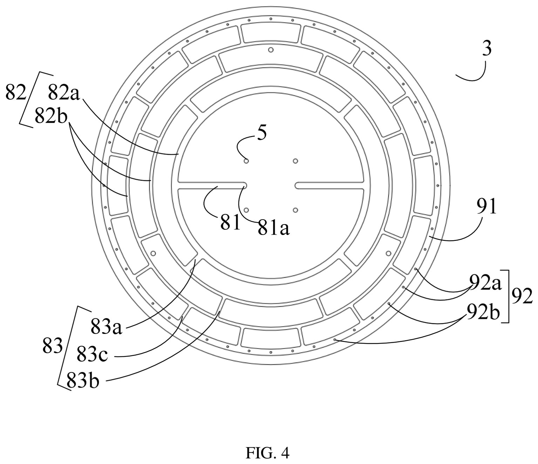

Specifically, the first gas distribution passage group includes at least one annular passage 82, multiple first connecting passages 81, and multiple second connecting passages 83. Taking multiple annular passages 82 as example, the multiple annular passages 82 are nested and spaced apart from each other, for example, the multiple annular passages 82 are all concentrically arranged with the center of the carrier surface. The second gas distribution passage group (a first buffer chamber 91 of the second gas distribution passage group is shown in FIG. 4 and described in detail below) surrounds the outer periphery of the outermost annular passage 82. The multiple first connecting passages 81 are all located in the space enclosed by the innermost annular passage 82a. Preferably, the multiple first connecting passages 81 are symmetrically distributed relative to the axis of the carrier surface, for example, symmetrically distributed relative to the center of the carrier surface. One end of each first connecting passage 81 serves as a gas inlet 81a, and another end of each first connecting passage 81 is connected to the innermost annular passage 82a. Multiple second connecting passages 83 connect each two adjacent annular passages 82, and also connect the outermost annular passage 82 to the second gas distribution passage group (i.e., the first buffer chamber 91). The multiple second connecting passages 83 between the outermost annular passage 82 and the second gas distribution passage group (i.e., the first buffer chamber 91) are spaced apart along the circumferential direction of the carrier surface; the multiple second connecting passages 83 between each two adjacent annular passages 82 are spaced apart along the circumferential direction of the annular passage 82.

The purging gas provided by the gas source can enter each first connecting passage 81 through the gas inlet 81a, and then be transported to the innermost annular passage 82a through each first connecting passage 81, thus completing the first gas distribution process. Due to the multiple first connecting passages 81, the purging gas can be divided into multiple paths from the gas inlet 81a and simultaneously flow into the innermost annular passage 82a at multiple different positions along its circumference. This allows the purging gas to spread quickly along the circumference of the innermost annular passage 82a, achieving uniform distribution in the circumferential direction, thereby improving the uniformity of the gas distribution. Preferably, by symmetrically arranging multiple first connecting passages 81 relative to the axis of the carrier surface, the uniformity of the purging gas distribution in the circumferential direction can be further improved, thereby improving the uniformity of the gas distribution.

Then, the purging gas flows into the adjacent outer annular passage 82b though each second connecting passage 83a, which is connected to the innermost annular passage 82a. After the purging gas is evenly spread circumferentially by this annular passage 82b, it then flows through the corresponding second connecting passages 83b into the next adjacent annular passage 82b, and so on, until it flows into the outermost second gas distribution passage group (i.e., the first buffer chamber 91), thus completing the second gas distribution process. The aforementioned first gas distribution passage group can transport the purging gas from the center to the edge of the carrier surface, so that it can be transported to the outermost second gas distribution passage group. Further, by using multiple first connecting passages 81, the purging gas can be transported from a position near the center of the carrier surface in different directions, and then through multiple annular passages 82 and multiple second connecting passages 83 connecting them, the purging gas can be finally transported to different positions in the circumferential direction of the second gas distribution passage group. This not only shortens the path of the purging gas and increases the flow rate of the purging gas, but also further improves the uniformity of the purging gas.

Because multiple annular passages 82 are interconnected, when the purging gas flows from each first connecting passage 81 or each second connecting passage 83 into the corresponding annular passage 82, it can quickly diffuse in the annular passage 82, achieving uniform distribution in the circumferential direction, thereby solving the problem of uneven gas flow distribution in the circumferential direction caused by directly delivering the purging gas to the outermost passage using a straight passage in existing technologies. Furthermore, the multiple interconnected annular passages 82 have lower flow resistance than straight passages, making them less susceptible to fluctuations in gas source pressure or flow rate. This effectively improves the distribution uniformity in the circumferential direction of the purging gas blown towards the edge of the wafer, thereby improving process uniformity.

It is easy to understand that the more annular passages 82 there are, the more times the purging gas is distributed, and the more uniformly the purging gas is distributed in the circumferential direction. In practical applications, the number of annular passages 82 can be set according to actual needs. Of course, under the premise of meeting actual needs, the number of annular passages 82 can also be one. In this case, the annular passage 82 is, for example, arranged along the circumferential direction of the carrier surface; the second gas distribution passage group surrounds the outer periphery of the annular passage 82; multiple first connecting passages 81 are located in the space enclosed by the annular passage 82; and the annular passage 82 and the second gas distribution passage group (i.e., the first buffer chamber 91) are connected through multiple second connecting passages 83. The purging gas provided by the gas source can enter each first connecting passage 81 through the inlet 81a, and then be transported to the annular passage 82 through each first connecting passage 81, thus completing the first gas distribution process.

In some embodiments, taking multiple annular passages 82 as an example, multiple second connecting passages 83 located on the same circumference are spaced apart along the circumferential direction of the annular passage 82, and the second connecting passages 83 located on different circumferences are staggered. By staggering the second connecting passages 83 located on different circumferences, the gas distribution uniformity can be improved, ensuring that the purging gas reaches the second gas distribution passage group uniformly.

Furthermore, in some embodiments, multiple second connecting passages 83 located on the same circumference are uniformly distributed along the circumferential direction of the annular passage 82, which can further improve the uniformity of the purging gas distribution in the circumferential direction.

In some embodiments, the radial width of the innermost annular passage 82a is greater than the radial width of the other annular passages 82b; and the width of each second connecting passage 83a connected to the innermost annular passage 82a is greater than the width of the other second connecting passages on different circumferences (e.g., second connecting passages 83b, 83c). Due to the larger radial width of the innermost annular passage 82a, its gas flow resistance is lower, allowing the purging gas to spread quickly circumferentially, achieving uniform distribution circumferentially and being less susceptible to fluctuations in gas source pressure or flow rate. Furthermore, since the width of the annular passages 82b other than the innermost annular passage 82a is relatively small, the gas flow resistance is higher, they effectively provide uniform gas distribution, ensuring that the purging gas reaches the second gas distribution passage group uniformly. Of course, in practical applications, the radial width of the innermost annular passage 82a can also be equal to the radial width of the other annular passages 82b, based on actual needs. In some embodiments, the width of each second connecting passage 83a connected to the innermost annular passage 82a can also be equal to the width of the other second connecting passages on different circumferences (e.g., second connecting passages 83b, 83c).

Further, in some embodiments, the radial widths of the annular passages 82b other than the innermost annular passage 82a are the same or decrease from the inside outwards. This can also achieve the above-mentioned effects. Further, in some embodiments, the widths of the second connecting passages on different circumferences (e.g., second connecting passages 83b, 83c). other than the second connecting passages 83a connected to the innermost annular passage 82a are the same or decrease from the inside outwards. This can also achieve the above-mentioned effects. In the embodiment of the present disclosure, the innermost annular passage 82a has the largest radial width compared to the other annular passages 82b. However, the present disclosure is not limited to this. In practical applications, there can be multiple annular passages 82 with the largest radial width, i.e., at least one annular passage 82 closer to the center of the carrier surface has a larger radial width than the other annular passages 82. The number of annular passages 82 with the largest radial width can be set according to actual needs. In some embodiments, if there is only one annular passage 82, its radial width is greater than the width of each second connecting passage. This can also achieve the above-mentioned effect.

Further, in some embodiments, the width of the first connecting passage 81 is the same as the radial width of the innermost annular passage 82a, or the width of multiple first connecting passages 81 is greater than the radial width of the innermost annular passage 82a. This can also achieve the above-mentioned effect.

In some embodiments, both the first connecting passage 81 and the second connecting passage 83 extend radially along the carrier surface. Furthermore, in some embodiments, the position at which each first connecting passage 81 connects to the innermost annular passage 82 is located at the at a middle position between two adjacent second connecting passages 83 that are connected to the annular passage 82. In this way, the purging gas flowing out of the first connecting passage 81 can reach the two nearest second connecting passages 83 after traveling the same distance, thereby further improving gas distribution uniformity.

In some embodiments, the position at which each second connecting passage 83 on a given circumference connects to the adjacent outer annular passage 82 is located at the at a middle position between two adjacent second connecting passages 83 on the adjacent outer circumference. In this way, the purging gas flowing out of each second connecting passage 83 can reach the two nearest second connecting passages 83 on the adjacent outer circumference after traveling the same distance, thereby further improving gas distribution uniformity.

In some embodiments, the second gas distribution passage group includes a first buffer chamber 91, a plurality of first pressure-regulating passages 92, a second buffer chamber 93, and a plurality of second pressure-regulating passages 94. The first buffer chamber 91 is annular and surrounds the outermost annular passage 82, and is connected to the outermost annular passage 82 through a plurality of second connecting passages 83c. The second buffer chamber 93 is annular and is spaced above the first buffer chamber 91, and the second buffer chamber 93 is connected to the first buffer chamber 91 through a plurality of first pressure-regulating passages 92. One end of each of the plurality of second pressure-regulating passages 94 is connected to the second buffer chamber 93, and the other end of each of the plurality of second pressure-regulating passages 94 serves as the aforementioned gas outlet 94a.

The purging gas in the outermost annular passage 82 flows into the first buffer chamber 91 through the second connecting passages 83c for initial flow equalization; then flows into the second buffer chamber 93 through the first pressure-regulating passages 92 for secondary flow equalization; and finally, the purging gas is blown out through the gas outlets 94a of the second pressure-regulating passages 94 towards the edge portion 4a of the wafer 4 placed on the carrier surface. Because the purging gas undergoes flow equalization twice through the two buffer chambers, and the first pressure-regulating passages 92 and the second pressure-regulating passages 94 can respectively pressurize the purging gas output from the first buffer chamber 91 and the second buffer chamber 93, this makes the blown purging gas more uniform, thereby further improving the uniformity of wafer edge purging, further improving the process uniformity of the wafer 4, and increasing the process yield.

In some embodiments, the volume of the first buffer chamber 91 is less than or equal to the volume of the second buffer chamber 93. The top plate 31 (described in detail below) in the carrier surface is usually made of ceramic material. When the first buffer chamber 91 is formed in the top plate 31, using a smaller volume for the first buffer chamber 91 facilitates the processing of the ceramic, making it less prone to cracking during the hot pressing and sintering process, thus improving the product yield. It should be noted that the present disclosure achieves uniform distribution of the purging gas in the circumferential direction by utilizing the annular passage 82 and the second connecting passages 83. Even with a smaller volume of the first buffer chamber 91, uniform gas distribution can be ensured.

In some embodiments, as shown in FIG. 4, the multiple first pressure-regulating passages 92 include multiple vertically arranged first through-holes 92a and multiple vertically arranged second through-holes 92b. Each second connecting passage 83c connected to the first buffer chamber 91 has a first through-hole 92a on each side. Preferably, the two first through-holes 92a located on either side of the second connecting passage 83c are symmetrically distributed with respect to the second connecting passage 83c. Each second connecting passage 83c connected to the first buffer chamber 91 also has a second through-hole 92b on each side. Preferably, the two second through-holes 92b located on either side of the second connecting passage 83c are symmetrically distributed with respect to the second connecting passage 83c. Furthermore, the second through-hole 92b is located on the side of the first through-hole 92a that is further away from the second connecting passage 83c. In this way, the purging gas flowing out of each second connecting passage 83c can reach the nearest two first through-holes 92a after traveling the same distance, and then diffuse to the nearest two second through-holes 92b after traveling the same distance, thereby further improving the uniformity of gas distribution. Of course, in practical applications, the above-mentioned second through-holes 92b can be omitted according to actual needs, i.e., only one first through-hole 92a is provided on each side of each second connecting passage 83 connected to the first buffer chamber 91; or, two or more second through-holes 92b can be provided on each side of each second connecting passage 83 connected to the first buffer chamber 91. There is no specific limitation on this in the embodiments of the present disclosure. Further, in some embodiments, the multiple first through-holes 92a and the multiple second through-holes 92b are equally spaced in the circumferential direction.

In some embodiments, the carrying device includes a carrier body 3 and an edge ring 33. The carrier body 3 has the aforementioned carrier surface, and the diameter of the carrier surface is smaller than the diameter of the wafer 4, so that the edge portion 4a of the wafer 4 can be located outside the carrier surface; as shown in FIG.s 3A and 3B, a first annular step member 311 is formed on the top of the outer circumferential surface of the carrier body 3. The edge ring 33 includes an annular body 331, and a first annular flange 332 is provided on the inner circumferential surface of the annular body 331. The first annular flange 332 is spaced above the first annular step member 311, and at least a part of the first annular flange 332 is located below the wafer 4, and the lower surface and inner circumferential surface of the first annular flange 332 respectively form the aforementioned second pressure-regulating passages 94 with the upper surface of the first annular step member 311 and the outer circumferential surface of the top plate 31. Further, in some embodiments, an annular groove is provided at the inner circumferential edge of the upper surface of the first annular flange 332. The bottom surface of the annular groove faces the edge region of the back surface of the wafer 4, and there is a gap between the bottom surface of the annular groove and the edge region of the back surface of the wafer 4 to form a part of the aforementioned outlet 94a, allowing the purging gas to be blown out. The annular side surface of the annular groove surrounds the wafer 4 and is used to define the position of the wafer 4.

A second annular step member 312 is formed on the outer circumferential surface of the carrier body 3 and below the first annular step member 311. A second annular flange 333 is formed on the inner circumferential surface of the annular body 331 and below the first annular flange 332. At least a part of the second annular flange 333 is superimposed on the second annular step member 312, and the inner circumferential surface of the second annular flange 333, the outer circumferential surface of the first annular step member 311, the upper surface of the second annular step member 312, and the lower surface of the first annular flange 332 form the aforementioned second buffer chamber 93.

In some embodiments, the carrier body 3 includes a top plate 31 and a bottom plate 32, in which, the bottom plate 32 is stacked on the lower surface of the top plate 31; and multiple annular passages 82, multiple first connecting passages 81, multiple second connecting passages 83, and a first buffer chamber 91 are formed between the upper surface of the bottom plate 32 and the lower surface of the top plate 31. Furthermore, in some embodiments, corresponding grooves can be formed in at least one of the upper surface of the bottom plate 32 and the lower surface of the top plate 31. For example, a corresponding groove can be formed on the upper surface of the bottom plate 32, and this groove, together with the lower surface of the top plate 31, encloses to form multiple annular passages 82, multiple first connecting passages 81, multiple second connecting passages 83, and the first buffer chamber. As another example, a corresponding groove can be formed on the lower surface of the top plate, and this groove, together with the upper surface of the bottom plate, encloses to form multiple annular passages 82, multiple first connecting passages 81, multiple second connecting passages 83, and the first buffer chamber. As another example, corresponding grooves can be formed on both the upper surface of the bottom plate 32 and the lower surface of the top plate 31, and these grooves together enclose to form multiple annular passages 82, multiple first connecting passages 81, multiple second connecting passages 83, and the first buffer chamber 91.

Multiple first pressure-regulating passages 92 are formed through the top plate 31, and the outlet end of each first pressure-regulating passage 92 is located on the upper surface of the second annular step member 312. Multiple gas inlet holes 321 are provided through the bottom plate 32, one end of each gas inlet hole 321 is connected to a corresponding gas inlet 81a, and the other end of each gas inlet hole 321 is connected to a gas source. The carrier body 3 is a split structure composed of the top plate 31 and the bottom plate 32. Combined with the use of the edge ring 33, this structure is simple and easy to manufacture, thus significantly reducing application and manufacturing costs. In some embodiments, the top plate 31 and the bottom plate 32 are sealing connected by welding.

In some embodiments, the carrying device also includes a support shaft 6, which is vertically arranged. The upper end of the support shaft 6 is fixedly connected to the bottom plate 32 at its center, for example, by welding. The gas inlet holes 321 in the bottom plate 32 can be connected to an external gas source through a gas inlet passage 62 located in the support shaft 6. The support shaft 6 can, for example, move up and down. In this case, the lower end of the support shaft 6 can extend from the bottom of the process chamber of the semiconductor processing apparatus to connect with an external lifting drive source. Furthermore, a bellows is fitted onto the support shaft 6 to seal the gap between the support shaft 6 and the process chamber, thereby ensuring the sealing of the process chamber.

In some embodiments, the top plate 31 can be a disc-shaped plate structure made of ceramic material. The bottom plate 32 can be a disc-shaped plate structure made of ceramic material.

In some embodiments, a heating component 7 can be provided inside the top plate 31 or the bottom plate 32. This heating component 7 is, for example, a heating wire or a heating tube, used to heat the wafer 4. Heating components 7 can be provided in different regions of the top plate 31 or bottom plate 32, respectively. For example, as shown in FIG. 2, there are two heating components 7, namely a first heating component 71 and a second heating component 72, which are respectively arranged corresponding to the central and edge regions of the top plate 31 or bottom plate 32 to achieve zoned temperature control.

In some embodiments, to achieve the vacuum suction function of the carrying device, the carrier body 3 (top plate 31 and bottom plate 32) also has multiple suction holes 5 that penetrate the carrier body 3. For example, FIG. 4 shows four suction holes 5, and the multiple suction holes 5 are evenly distributed along the circumference of the carrier body 3 and are staggered with respect to the gas inlet 81a. Each suction hole 5 can be connected to an external vacuum suction device through an suction passage 61 located in the support shaft 6.

In a specific embodiment, corresponding grooves are formed on the lower surface of the top plate 31, and these grooves, together with the upper surface of the bottom plate 31, form multiple annular passages 82, multiple first connecting passages 81, multiple second connecting passages 83, and a first buffer chamber 91. There are three annular passages 82, arranged at equal intervals; the radial width of the innermost annular passage 82a is greater than the radial width of the other two annular passages 82b, and the radial widths of the other two annular passages 82b are equal. There are two first connecting passages 81, and the width of the first connecting passages 81 is the same as the radial width of the innermost annular passage 82a, for example, 6 mm. The width of each second connecting passage 83a connected to the innermost annular passage 82a is greater than the width of the second connecting passages on other different circumferences (e.g., second connecting passages 83b, 83c); the width of the second connecting passages on other different circumferences (e.g., second connecting passages 83b, 83c) is the same, for example, 3 mm. The number of second connecting passages 83a connected to the innermost annular passage 82a is 4, and the number of second connecting passages on different circumferences (e.g., second connecting passages 83b, 83c) increases from the inside out, with an increase of 2 times. The multiple first pressure-regulating passages 92 include multiple vertically arranged first through holes 92a and multiple vertically arranged second through holes 92b. The total number of first through holes 92a and second through holes 92b is 48, in which, there are 32 first through holes 92a and 16 second through holes 92b. The depth of the annular passages 82, the first connecting passages 81, and the second connecting passages 83 is the same, for example, 2 mm.

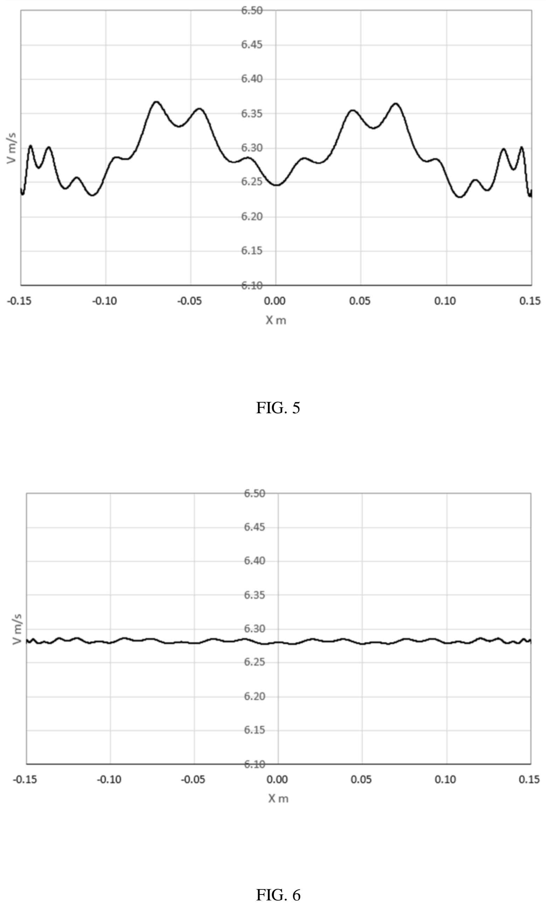

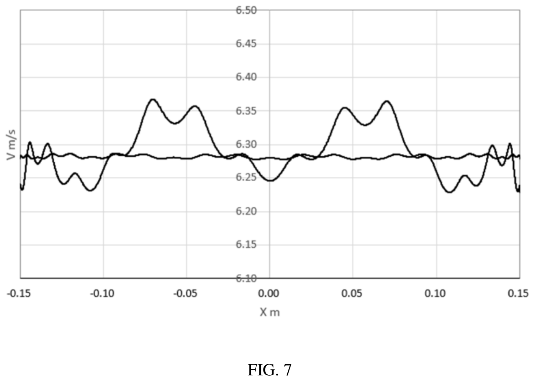

FIG. 5 is a graph showing the relationship between gas flow rate and chuck diameter for a carrying device provided in the related art. FIG. 6 is a graph showing the relationship between gas flow rate and chuck diameter for a carrying device provided in the embodiment of the present disclosure. FIG. 7 is a comparison chart of the curves shown in FIG. 5 and FIG. 6. The carrying device provided in the related art shown in FIG. 1 uses the purging passage structure shown in FIG. 1. Specifically, the purging gas is guided to the buffer chamber 2 at the edge of the chuck through multiple horizontal straight passages 1, and then the purging gas is guided to the edge region of the wafer 4 through corresponding passages, so that the purging gas can be blown out towards the back and sides of the wafer 4. The curves shown in FIG.s 6 and 7 were obtained through simulation calculations using the same simulation conditions: the purging gas provided by the gas source was argon (Ar), the intake gas flow rate was 800 sccm, and the intake gas temperature was room temperature; the temperature of the heating component in the carrying device was 400°C; and the chamber wall temperature of the process chamber was 120°C. The comparison shows that the purging gas flow fluctuation is smaller and the gas flow uniformity is better in the carrying device provided in the embodiment of the present disclosure.

As another technical solution, embodiments of the present disclosure also provide a semiconductor processing apparatus, including a process chamber and a carrying device disposed in the process chamber. The carrying device is the carrying device described in the embodiment of the present disclosure.

The semiconductor processing apparatus provided in the embodiment of the present disclosure, by using the carrying device described in the embodiment of the present disclosure, can effectively improve the uniformity of the purging gas distribution in the circumferential direction towards the edge of the wafer, thereby improving process uniformity.

It can be understood that the above embodiments are merely exemplary embodiments used to illustrate the principles of the present disclosure, and the present disclosure is not limited thereto. For those skilled in the art, various modifications and improvements can be made without departing from the spirit and essence of the present disclosure, and these modifications and improvements are also considered to be within the scope of protection of the present disclosure.

## Claims

1. A carrying device, comprising a carrier surface for carrying a wafer, wherein, the carrying device is provided with a purging passage structure for transporting purging gas, the purging passage structure includes a first gas distribution passage group and a second gas distribution passage group interconnected with each other, the first gas distribution passage group having an inlet for connecting to a gas source; the second gas distribution passage group having an outlet for blowing the purging gas towards the edge region of the wafer placed on the carrier surface;
the first gas distribution passage group includes at least one annular passage, a plurality of first connecting passages and a plurality of second connecting passages, the second gas distribution passage group is arranged around the periphery of the annular passage;
the plurality of first connecting passages are all located in the space enclosed by the annular passage, one end of each of the first connecting passages serving as the inlet, and the other end being connected to the annular passage;
the annular passage and the second gas distribution passage group are connected through the plurality of second connecting passages; and the plurality of second connecting passages are spaced apart along the circumferential direction of the annular passage.

2. The carrying device according to claim 1, wherein, there are multiple annular passages, which are nested and spaced apart from each other;
each two adjacent annular passages, and the outermost annular passage and the second gas distribution passage group are connected through a plurality of second connecting passages;
and the plurality of second connecting passages located on the same circumference are spaced apart along the circumference, and the second connecting passages located on different circumferences are staggered with each other;
the plurality of first connecting passages are all located in the space enclosed by the innermost annular passage, and the other end of the first connecting passage is connected to the innermost annular passage; the second gas distribution passage group surrounds the periphery of the outermost annular passage.

3. The carrying device according to claim 1, wherein, the plurality of second connecting passages are uniformly distributed along the circumferential direction of the annular passage.

4. The carrying device according to claim 2, wherein, the radial width of the innermost annular passage is greater than the radial width of the other annular passages;
the width of each of the second connecting passages connected to the innermost annular passage is greater than the width of the second connecting passages on other different circumferences.

5. The carrying device according to claim 4, wherein, the radial widths of the annular passages other than the innermost annular passage are the same or decrease from the inside to the outside.

6. The carrying device according to claim 4, wherein, the radial widths of the second connecting passages on different circumferences, other than the second connecting passages connected with the innermost annular passage, are the same or decrease from the inside to the outside.

7. The carrying device according to claim 2, wherein, both the first connecting passages and the second connecting passages are arranged to extend radially along the carrier surface;
the position at which each first connecting passage connects to the innermost annular passage is located at a middle position between two adjacent second connecting passages that connect to that annular passage.

8. The carrying device according to claim 7, wherein, the position at which each second connecting passage on each circumference connects to the adjacent outer annular passage is located at a middle position between two adjacent second connecting passages on the adjacent outer circumference.

9. The carrying device according to any one of claims 1-8, wherein, the second gas distribution passage group includes a first buffer chamber, a plurality of first pressure-regulating passages, a second buffer chamber, and a plurality of second pressure-regulating passages, wherein,
the first buffer chamber is annular and surrounds the periphery of the outermost annular passage, and is connected to the outermost annular passage through a plurality of the second connecting passages;
the second buffer chamber is annular and is spaced above the first buffer chamber, and the second buffer chamber and the first buffer chamber are connected through a plurality of the first pressure-regulating passages;
one end of each of the plurality of second pressure-regulating passages is connected to the second buffer chamber, and the other end of each of the plurality of second pressure-regulating passages serves as the gas outlet.

10. The carrying device according to claim 9, wherein, the volume of the first buffer chamber is less than or equal to the volume of the second buffer chamber.

11. The carrying device according to claim 9, wherein, the plurality of first pressure-regulating passages include a plurality of vertically arranged first through holes and a plurality of vertically arranged second through holes, wherein each of the second connecting passages connected with the first buffer chamber has a first through hole on each side;
each of the second connecting passages connected with the first buffer chamber has a second through hole on each side, and the second through hole is located on a side of the first through hole on the same side thereof that is facing away from the second connecting passage.

12. The carrying device according to claim 9, wherein, the carrying device includes a carrier body and an edge ring, wherein the carrier body has the carrier surface, and the diameter of the carrier surface is smaller than the diameter of the wafer, so that the edge region of the wafer can be located outside the carrier surface; a first annular step member is formed on the top of the outer circumferential surface of the carrier body,
the edge ring includes an annular body, and a first annular flange is provided on the inner circumferential surface of the annular body, the first annular flange is spaced above the first annular step member, and at least a part of the first annular flange is located below the wafer, and the lower surface and inner circumferential surface of the first annular flange respectively form the second pressure-regulating passage with the upper surface of the first annular step member and the outer circumferential surface of the carrier body;
a second annular step member is formed on the outer circumferential surface of the carrier body and below the first annular step member, and a second annular flange is formed on the inner circumferential surface of the annular body and below the first annular flange, at least a part of the second annular flange is superimposed on the second annular step member, and the inner circumferential surface of the second annular flange, the outer circumferential surface of the first annular step member, the upper surface of the second annular step member, and the lower surface of the first annular flange form the second buffer chamber.

13. The carrying device according to claim 12, wherein, the carrier body comprises a top plate and a bottom plate superimposed on the lower surface of the top plate, wherein a plurality of the annular passages, a plurality of the first connecting passages, a plurality of the second connecting passages, and the first buffer chamber are formed between the upper surface of the bottom plate and the lower surface of the top plate;
a plurality of the first pressure-regulating passages are formed through the top plate, and the gas outlet end of each of the first pressure-regulating passages is located on the upper surface of the second annular step member;
a plurality of gas inlet holes are provided through the bottom plate, one end of the plurality of gas inlet holes is connected to the plurality of gas inlets in a one-to-one correspondence, and the other end of the plurality of the gas inlet holes is used to connect to the gas source.

14. A semiconductor processing apparatus, comprising a process chamber and a carrying device disposed in the process chamber, wherein the carrying device is the carrying device described in any one of claims 1-13.
